# EUROPÄISCHE PATENTANMELDUNG

(11) **EP 2 085 702 A2**
(43) Veröffentlichungstag der Anmeldung: **05.08.2009**
(21) Anmeldenummer: 09100076.0
(22) Anmeldetag: 27.01.2009
(51) Int. Cl.: F24C 15/10

(54) **Hausgerät mit einer Markierung und mit einer Beleuchtungsanordnung**

(30) Priorität: 04.02.2008 ES 200800392
(71) Anmelder: BSH Bosch und Siemens Hausgeräte GmbH, 81739 München (DE)
(72) Erfinder: Buñuel Magdalena, Miguel Angel, 50017 Zaragoza (ES); López Gascón, Clara Isabel, 50007 Zaragoza (ES); Santolaria Lorenzo, Jose Alfonso, 22400 Monzón (Huesca) (ES); Schmalenstrot, Rene, 50010 Zaragoza (ES); Sola Martinez, Daniel, 50015 Zaragoza (ES)

(57) **Zusammenfassung**

Die Erfindung geht aus von einem Hausgerät, insbesondere einem Kochfeld, mit einer Abdeckplatte (10) aus einem transparenten oder semitransparenten Material und einer im Inneren und/oder auf einer Oberfläche der Abdeckplatte (10) angebrachten Markierung (12) und mit einer Beleuchtungsanordnung (14) zum Hinterleuchten der Markierung (12).

Um eine homogene Ausleuchtung der Markierung (12) zu erreichen, wird vorgeschlagen, dass die Beleuchtungsanordnung (14) ein Illuminationsmittel (16) zum Hinterleuchten der Markierung (12) von einer Rückseite der Abdeckplatte (10) aus umfasst.

## Beschreibung

Die Erfindung geht aus von einem Hausgerät mit einer Markierung und mit einer Beleuchtungsanordnung nach dem Oberbegriff des Anspruchs 1.

Aus der EP 0 432 653 A1 ist ein Hausgerät, und zwar ein Kochfeld, mit einer Abdeckplatte aus einem transparenten oder semitransparenten Glas- oder Keramikmaterial bekannt. Es wird ein Verfahren zum Herstellen von Großflächendekoren und Markierungen auf einer Oberfläche der Abdeckplatte beschrieben. Aus dem Stand der Technik ist es ferner bekannt, gattungsgemäße Hausgeräte mit einer Beleuchtungsanordnung zum Hinterleuchten der Markierung auszustatten. Beispielsweise wurde bereits vorgeschlagen, Laser-Gravuren einer Abdeckplatte aus Glas oder Glaskeramik zu beleuchten, indem Leuchtdioden an einer seitlichen Randfläche der Abdeckplatte angeordnet werden. Das von den Leuchtdioden erzeugte Licht wird über die schmalen Stirnseiten der Abdeckplatte in das Glas- oder Glaskeramikmaterial eingekoppelt und propagiert durch Totalreflexion an der oberen und der unteren Oberfläche der Abdeckplatte in den Bereich der Markierung, wo es von der Markierung derart gestreut wird, dass Anteile von Streulicht in einem stumpfen Winkel auf die Oberflächen auftreffen und aus dem Glas- oder Glaskeramikmaterial austreten können. Die Laser-Innengravur scheint so als scheinbar aktiv leuchtendes Objekt.

Der Erfindung liegt insbesondere die Aufgabe zugrunde, ein gattungsgemäßes Hausgerät mit einer Beleuchtungsvorrichtung auszustatten, die in der Lage ist, eine Markierung der Abdeckplatte gleichmäßiger auszuleuchten.

Die Aufgabe wird gelöst durch die Merkmale des unabhängigen Anspruchs 1. Vorteilhafte Ausgestaltungen und Weiterbildungen der Erfindung ergeben sich aus den Unteransprüchen.

Die Erfindung betrifft insbesondere ein Hausgerät mit einer Abdeckplatte aus einem transparenten oder semitransparenten Glas- oder Keramikmaterial und einer im Inneren und/oder auf der Oberfläche der Abdeckplatte angebrachten Markierung. Das Hausgerät umfasst ferner eine Beleuchtungsanordnung zum Beleuchten dieser Markierung.

Es wird vorgeschlagen, dass die Beleuchtungsanordnung ein Illuminationsmittel zum Hinterleuchten der Markierung von einer Rückseite der Abdeckplatte aus umfasst. Dadurch kann im Vergleich zu Hausgeräten, in welchen die Beleuchtungsanordnung Licht über eine schmale Randfläche der Abdeckplatte in das Glas- oder Keramikmaterial einkoppelt, eine deutlich verbesserte Lichtausbeute erreicht werden, und es kann in einer einfachen Weise eine homogene Ausleuchtung der Markierung geschaffen werden. Schlagschatten können vermieden werden. Es ist insgesamt ein besonders ansprechendes Design erreichbar, und die gleichmäßige Ausleuchtung der Markierung kann einen besonders hochwertigen Gesamteindruck erzeugen.

Als "Rückseite" der Abdeckplatte soll eine im Betrieb für den Benutzer unzugängliche Seite der Abdeckplatte, die einem Innenraum eines Gehäuses des Hausgeräts bzw. Heizelementen des Hausgeräts zugewandt ist, bezeichnet werden. Ebenso beziehen sich Angaben wie "oben", "unten", "innen" und "außen" auf die Einbaukonfiguration des Hausgeräts bzw. auf das Innere und Äußere des Hausgerätgehäuses.

Das transparente Material kann Glas- oder Keramikmaterial oder auch Kunststoff sein, wobei beim Einsatz in Kochfeldern wegen der erforderlichen Hitzebeständigkeit Glas- oder Keramikmaterialien als besonders geeignet erscheinen.

In einer besonders vorteilhaften Ausgestaltung der Erfindung ist das Hausgerät als Kochfeld mit einer transparenten oder semitransparenten Abdeckplatte ausgebildet. Die Beleuchtungsanordnung und die Markierung kann insbesondere im Bereich einer berührungsempfindlichen Benutzerschnittstelle bzw. einer "Touch-Control" - Einheit angeordnet sein, die eine transparente Abdeckplatte aus Glas oder Glaskeramik und hinter der Abdeckplatte angeordnete kapazitive oder induktive Berührungssensoren umfassen kann. Das Illuminationsmittel und die Markierung können in einem Bereich der Benutzerschnittstelle angeordnet sein, der frei von solchen Berührungssensoren ist.

In einer Weiterbildung der Erfindung wird vorgeschlagen, dass die Markierung aus LaserGravur, insbesondere als dreidimensionale Laser-Innengravur des Glas- oder Keramikmaterials ausgebildet ist. Durch die gleichmäßige Ausleuchtung der Markierung von der Rückseite der Abdeckplatte aus können derartige Innengravuren besonders in Szene gesetzt werden. Als dreidimensionale Laser-Innengravur soll eine Struktur bezeichnet werden, in welcher mit einem Laser in mehreren parallel zu der Oberseite und Unterseite der Abdeckplatte verlaufenden Schichten fokussiert wurde, um gezielt Materialeffekte in das Glas- oder Glaskeramikmaterial einzuarbeiten.

Eine besonders homogene Ausleuchtung der Markierung kann erreicht werden, wenn das Illuminationsmittel einen plattenförmigen Lichtleiter umfasst, der im Bereich der Markierung hinter der Abdeckplatte angeordnet ist. Insbesondere kann der plattenförmige Lichtleiter parallel zu der Unterseite bzw. Rückseite der Abdeckplatte angeordnet sein und/oder an dieser anliegen.

Die Brechungseigenschaften des Lichts beim Übergang von dem Illuminationsmittel zu der Abdeckplatte können vorteilhaft gestaltet werden, wenn das Illuminationsmittel mit einer Kontaktfläche im Bereich der Markierung mit der Rückseite der Abdeckplatte verklebt ist. Dadurch können ferner Verunreinigungen in einem Spalt zwischen dem Illuminationsmittel und der Rückseite der Abdeckplatte vermieden werden.

Das Illuminationsmittel kann nach einer besonders vorteilhaften Ausgestaltung der Erfindung eine Leuchtdioden-Halbleiterschicht umfassen, deren Fläche zumindest im Wesentlichen eine Fläche der Markierung überdeckt. Unter Umständen kann eine homogene Ausleuchtung der Markierung auch schon dann erreicht werden, wenn die Halbleiter mehr als 70% bis 90% der Fläche der Markierung ausmachen.

Ferner wird vorgeschlagen, dass die Leuchtdioden-Halbleiterschicht über wenigstens eine transparente Elektrodenschicht betrieben werden kann, die in einer besonders vorteilhaften Ausgestaltung der Erfindung zwischen der Leuchtdioden-Halbleiterschicht und der Rückseite der Abdeckplatte angeordnet ist. Eine zweite Elektrodenschicht, welche die Leuchtdioden-Halbleiterschicht an einer der Abdeckplatte abgewandten Rückseite des Illuminationsmittels kontaktiert, kann aus Kostengründen andersartig ausgestaltet sein, beispielsweise als einfache Metallschicht, die vorteilhaft reflektierende Eigenschaften haben kann.

Wenn die Beleuchtungsanordnung wenigstens eine Leuchtdiode umfasst, die zum Einstrahlen von Licht in eine Seitenfläche des Illuminationsmittels ausgelegt ist, kann ein besonders flaches Illuminationsmittel in einer Bauraum sparenden Weise in das Hausgerät integriert werden.

Eine homogene Ausleuchtung der Markierung kann trotz der seitlichen Einstrahlung erreicht werden, wenn das Illuminationsmittel in zumindest einem hinter der Markierung angeordneten Bereich gleichmäßig verteilte Diffusionszentren zum Homogenisieren der Bestrahlung der Markierung aufweist. Die Diffusionszentren können beliebige Größen von atomaren Größenskalen bis in den Bereich von mehreren Mikrometern haben und makroskopisch durch eine im Vergleich zu transparentem Standardglas hohe Diffusivität beschreibbar sein. Es kann erreicht werden, dass das Material des Illuminationsmittels durch die Diffusionszentren milchig erscheint, was zu einer homogenen Auskopplung des von der Seite eingestrahlten Lichts an der Kontaktfläche des Illuminationsmittels führt. Auf dieser Art können besonders effektvolle Markierungen und/oder eine Markierung mit einer Anzeigefunktion ermöglicht werden.

Die Anzeigefunktion der Markierung kann insbesondere dann realisiert werden, wenn das Hausgerät eine Steuereinheit zum Betätigen der Beleuchtungsanordnung umfasst und wenn die Steuereinheit dazu ausgelegt ist, eine Intensität, Größe und Form und/oder Farbe der Beleuchtung abhängig von einem Betriebszustand des Hausgeräts zu bestimmen. Beispielsweise kann die Intensität und Farbe der Beleuchtung der Markierung Aufschluss über einen Betriebszustand des Hausgeräts und/oder einer Restwärme einer Heizzone ergeben.

Wenn die Rückseite der Abdeckplatte mit einer einseitig lichtdurchlässigen Spiegelschicht, insbesondere einer dünnen Metallschicht, ausgestattet ist, kann ein besonders eindrucksvoller optischer Effekt erzielt werden.

Weitere Vorteile ergeben sich aus der folgenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

### Es zeigen:

- Fig. 1: ein Hausgerät mit einer Abdeckplatte aus Glaskeramik und einer Markierung nach einem ersten Ausführungsbeispiel der Erfindung,
- Fig. 2: die Abdeckplatte mit einer Beleuchtungsanordnung in einer perspektivischen Ansicht von einer Rückseite,
- Fig. 3: eine Abdeckplatte mit einer Beleuchtungsanordnung und einem Illuminationsmittel, das eine Leuchtdioden-Halbleiterschicht umfasst, nach einer weiteren alternativen Ausgestaltung der Erfindung in einer Schnittdarstellung,
- Fig. 4: eine Beleuchtungsanordnung zum Beleuchten einer Markierung nach einer weiteren Ausgestaltung der Erfindung, in welcher die Beleuchtungsanordnung Mittel zum Hinterleuchten der Markierung in zwei unterschiedlichen Farben aufweist und
- Fig. 5: eine Beleuchtungsanordnung zum Beleuchten einer Markierung nach einer weiteren Ausgestaltung der Erfindung, in welcher einer Rückseite der Abdeckplatte des Hausgeräts mit einer semitransparenten Spiegelschicht ausgestattet ist.

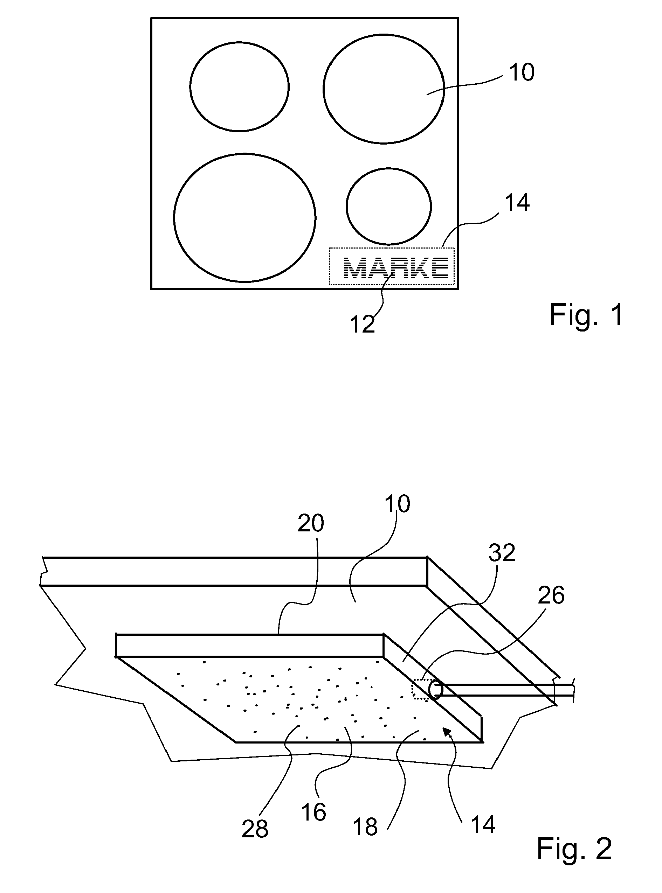

Figur 1 zeigt schematisch ein als Induktionskochfeld ausgebildetes Hausgerät mit einer Abdeckplatte 10 aus Glaskeramik und einer Markierung 12, die beispielsweise ein Hersteller-Logo oder eine Visualisierung und/oder Erläuterung zur Funktion einer Bedienerschnittstelle sein kann. Das Hausgerät umfasst ferner eine Beleuchtungsanordnung 14, die die Markierung 12 von einer Rückseite der Abdeckplatte 10 bzw. von einem Innenraum eines hier nicht dargestellten Gehäuses des Hausgeräts aus beleuchtet.

Die Markierung 12 ist als zwei- oder dreidimensionale Laser-Innengravur des Glaskeramikmaterials ausgebildet und ist dadurch hergestellt, dass der Laserstrahl in verschiedenen Punkten im Inneren des Glaskeramikmaterials der Abdeckplatte 10 fokussiert wird, und zwar derart, dass im Fokus des Laserstrahls mikroskopische Risse oder Materialdefekte entstehen, die die optischen Eigenschaften des Glaskeramikmaterials in diesem Punkt ändern. Der Laserstrahl wird dabei so gesteuert, dass die Gesamtheit der derart erzeugten Punkte eine dreidimensionale oder zweidimensionale Struktur im Inneren des Glaskeramikmaterials bildet, die sich dem Bediener als Markierung 12 darstellt.

Neben Hersteller-Logos können selbstverständlich auch andere Markierungen an anderen Stellen, beispielsweise Umgrenzungslinien von Heizzonen des Hausgeräts, Beschriftungen oder Piktogramme zum Visualisieren von Funktionen von Benutzerschnittstellen mit dieser Technik hergestellt und auf die Beschriebene Weise illuminiert werden.

Figur 2 zeigt die Abdeckplatte 10 und die Beleuchtungsanordnung 14 in einer perspektivischen Ansicht von schräg unten. Die Beleuchtungsanordnung umfasst ein im Bereich der Markierung 12 mit einer der Rückseite der Abdeckplatte 10 verklebtes Illuminationsmittel 16. Das Illuminationsmittel 16 ist als plattenförmiger bzw. scheibenförmiger Lichtleiter 18 in Kombination mit einer Leuchtdiode 26 ausgebildet. Die Leuchtdiode 26 ist an einer Seitenfläche 32 des Lichtleiters 18 angeordnet. Die Seitenfläche 32 verläuft senkrecht zu einer Erstreckungsebene des plattenförmigen Lichtleiters 18, der insgesamt parallel zu der Abdeckplatte 10 angeordnet ist. Der zum Verkleben des Lichtleiters 18 mit der Abdeckplatte 10 verwendete Klebstoff (nicht dargestellt) hat einen geringeren Brechungsindex als der zur Herstellung des Lichtleiters 18 verwendete transparente Kunststoff und das Glas der Abdeckplatte, so dass am Übergang zwischen dem Lichtleiter 18 und dem Klebstoff ein Teil des von der Leuchtdiode 26 erzeugten Lichts total reflektiert wird.

Das von der Leuchtdiode 26 erzeugte Licht wird von dem Lichtleiter 18 in den Bereich der Markierung 12 geleitet und über eine Kontaktfläche 20, die über die Klebeverbindung mittelbar an der Rückseite der Abdeckplatte 10 anliegt, in das transparente Glaskeramikmaterial der Abdeckplatte 10 eingekoppelt. Das derart in das Glaskeramikmaterial eingekoppelte Licht wird an der Markierung 12 gestreut, so dass die Markierung 12 insgesamt schwebend und aktiv leuchtend erscheint. Durch das Einkoppeln des Lichts von der Rückseite der Abdeckplatte 10 aus können Schlagschatten der Markierung 12 sicher vermieden werden.

Der Lichtleiter 18 ist aus transparentem Kunststoff gefertigt, kann jedoch in alternativen Ausführungsbeispielen auch aus transparentem Glas oder Glaskeramik gefertigt werden. In das transparente Material des Lichtleiters 18 sind homogen verteilte Diffusionszentren 28 eingearbeitet, die beispielsweise Kolloidteilchen oder andersartige Streuzentren in dem ansonsten transparenten Kunststoffmaterial des Lichtleiters 28 sein können.

Um Verluste zu vermeiden, ist eine der Abdeckplatte 10 abgewandte Rückseite des Lichtleiters 18 verspiegelt.

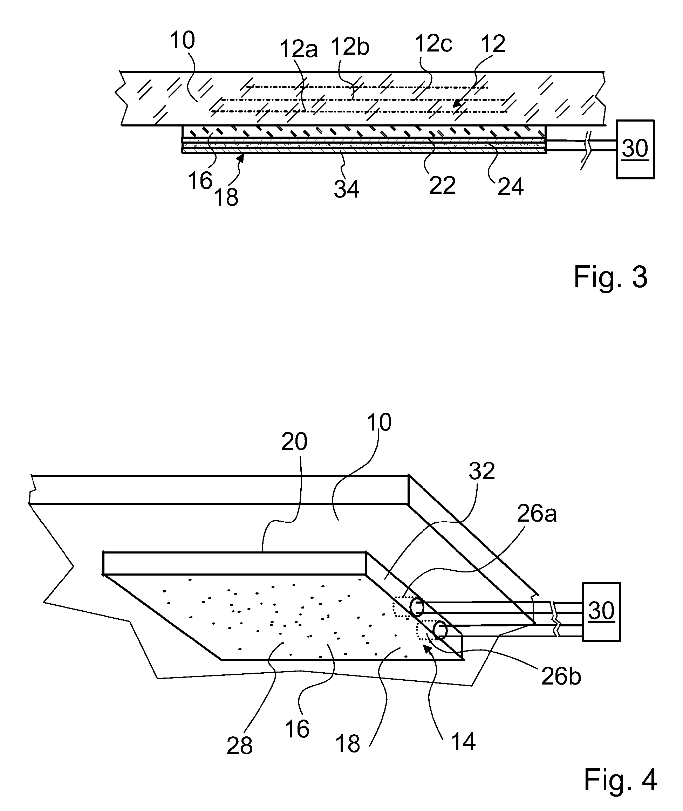

Figur 3 zeigt eine Schnittdarstellung einer Abdeckplatte 10 eines Hausgeräts und eines Illuminationsmittels 16 einer Beleuchtungsanordnung 14 zum Beleuchten einer Markierung 12 in einer alternativen Ausgestaltung der Erfindung. Es ist erkennbar, dass die Markierung 12 in drei parallelen Schichten 12a, 12b, 12c in das Material der Abdeckplatte 10 eingraviert ist, so dass insgesamt eine dreidimensionale Struktur der Markierung 12 entsteht.

Das Illuminationsmittel 16 umfasst eine Leuchtdioden-Halbleiterschicht 24, eine zwischen der Leuchtdioden-Halbleiterschicht 24 und der Abdeckplatte 10 angeordnete transparente Elektrodenschicht 22 und eine an einer der Abdeckplatte 10 abgewandten Rückseite des Illuminationsmittels 16 angeordnete zweite, metallische und reflektierende Elektrodenschicht 34. Das Illuminationsmittel 16 bildet ein flächiges Leuchtmittel, das in einer senkrechten Projektion die Fläche der Markierung 12 überdeckt.

Das Illuminationsmittel weist ferner Kontakte zum Ansteuern der Elektrodenschichten 22, 34 auf, und das Hausgerät umfasst eine Steuereinheit 30, die das Illuminationsmittel 16 abhängig von einem Betriebszustand des Hausgeräts und/oder einer Restwärme des Hausgeräts betreibt. Die Steuereinheit 30 kann das Illuminationsmittel 16 beispielsweise zum Anzeigen eines Standby-Zustands nutzen und dazu das Illuminationsmittel 16 immer dann betätigen, wenn das Hausgerät betriebsbereit ist.

Figur 4 zeigt ein weiteres alternatives Ausführungsbeispiel der Erfindung. Das in Figur 4 dargestellte Ausführungsbeispiel ähnelt stark dem in Figur 2 dargestellten Ausführungsbeispiel, so dass im Hinblick auf die gleich bleibenden Merkmale auf die Beschreibung zu den Figuren 1 und 2 verwiesen werden kann. Im Unterschied zu dem in Figur 2 dargestellten Ausführungsbeispiel sind an einer Seitenfläche 32 eines Illuminationsmittels 16 einer Beleuchtungsanordnung 14 zwei Leuchtdioden 26a, 26b zum Beleuchten einer Markierung 12 des Hausgeräts angeordnet.

Die Leuchtdioden 26a, 26b erzeugen Licht in unterschiedlichen Farben, so dass sie Mittel zum Hinterleuchten der Markierung 12 in unterschiedlichen Farben bilden. Die Leuchtdioden 26a, 26b sind über eine Steuereinheit 30 betätigbar, die eine Farbe und Intensität der Beleuchtung, abhängig von einem Betriebszustand des Hausgeräts, bestimmt.

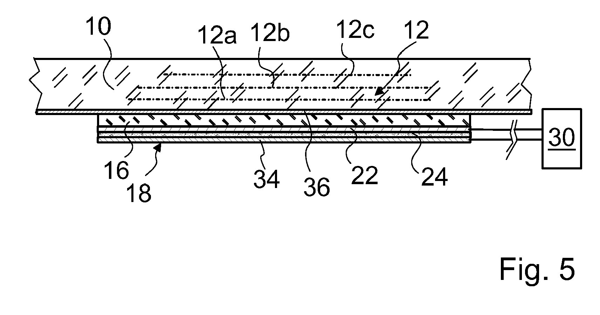

Figur 5 zeigt eine Beleuchtungsanordnung zum Beleuchten einer Markierung nach einer weiteren Ausgestaltung der Erfindung, in welcher einer Rückseite der Abdeckplatte 10 im Bereich der Markierung 12 des Hausgeräts mit einer semitransparenten Spiegelschicht 36 ausgestattet ist. Die Spiegelschicht 36 ist eine dünne Metallschicht, die von der Vorderseite der Abdeckplatte 10 aus einfallendes Licht vollständig reflektiert und von der Beleuchtungsanordnung 14 erzeugtes Licht durchlässt.

### Bezugszeichen

- 10: Abdeckplatte
- 12: Markierung
- 14: Beleuchtungsanordnung
- 16: Illuminationsmittel
- 18: Lichtleiter
- 20: Kontaktfläche
- 22: Elektrodenschicht
- 24: Leuchtdioden-Halbleiterschicht
- 26: Leuchtdiode
- 28: Diffusionszentrum
- 30: Steuereinheit
- 32: Seitenfläche
- 34: Elektrodenschicht
- 36: Spiegelschicht

## Patentansprüche

1. Hausgerät mit einer Abdeckplatte (10) aus einem transparenten oder semitransparenten Material und einer im Inneren und/oder auf einer Oberfläche der Abdeckplatte (10) angebrachten Markierung (12) und mit einer Beleuchtungsanordnung (14) zum Hinterleuchten der Markierung (12), **dadurch gekennzeichnet, dass** die Beleuchtungsanordnung (14) ein Illuminationsmittel (16) zum Hinterleuchten der Markierung (12) von einer Rückseite der Abdeckplatte (10) aus umfasst.

2. Hausgerät nach Anspruch 1, **dadurch gekennzeichnet, dass** das Hausgerät als Kocheld ausgebildet ist.

3. Hausgerät nach einem der vorhergehenden Ansprüche, **dadurch gekennzeichnet, dass** die Markierung (12) als Lasergravur ausgebildet ist.

4. Hausgerät nach einem der vorhergehenden Ansprüche, **dadurch gekennzeichnet, dass** die Markierung (12) als dreidimensionale Laser-Innengravur des Materials ausgebildet ist.

5. Hausgerät nach einem der vorhergehenden Ansprüche, **dadurch gekennzeichnet, dass** das Illuminationsmittel (16) einen plattenförmigen Lichtleiter (18) umfasst, der im Bereich der Markierung (12) hinter der Abdeckplatte (10) angeordnet ist.

6. Hausgerät nach einem der vorhergehenden Ansprüche, **dadurch gekennzeichnet, dass** das Illuminationsmittel (16) mit einer Kontaktfläche (20) im Bereich der Markierung (12) mit der Rückseite der Abdeckplatte (10) verklebt ist.

7. Hausgerät nach einem der vorhergehenden Ansprüche, **dadurch gekennzeichnet, dass** das Illuminationsmittel (16) eine Leuchtdioden-Halbleiterschicht (24) umfasst, deren Fläche zumindest im Wesentlichen eine Fläche der Markierung (12) überdeckt.

8. Hausgerät nach Anspruch 7, **dadurch gekennzeichnet, dass** das Illuminationsmittel (16) wenigstens eine transparente Elektrodenschicht (22) aufweist, die zwischen der Leuchtdioden-Halbleiterschicht (24) und der Abdeckplatte (10) angeordnet ist.

9. Hausgerät nach einem der vorhergehenden Ansprüche, **dadurch gekennzeichnet, dass** die Beleuchtungsanordnung (14) wenigstens eine Leuchtdiode (26, 26a, 26b) umfasst, die zum Einstrahlen von Licht in eine Seitenfläche (32) des IIluminationsmittels (16) ausgelegt ist.

10. Hausgerät nach einem der vorhergehenden Ansprüche, **dadurch gekennzeichnet, dass** das Illuminationsmittel (16) in zumindest einem hinter der Markierung (12) angeordneten Bereich gleichmäßig verteilte Diffusionszentren (28) zum Homogenisieren der Bestrahlung der Markierung (12) aufweist.

11. Hausgerät nach einem der vorhergehenden Ansprüche, **dadurch gekennzeichnet, dass** die Beleuchtungsanordnung (14) Mittel (26a, 26b) zum Hinterleuchten der Markierung (12) in wenigstens zwei unterschiedlichen Farben aufweist.

12. Hausgerät nach einem der vorhergehenden Ansprüche, **gekennzeichnet durch** eine Steuereinheit (30) zum Betätigen der Beleuchtungsanordnung (14), wobei die Steuereinheit (30) dazu ausgelegt ist, eine Intensität und/oder Farbe der Beleuchtung abhängig von einem Betriebszustand des Hausgeräts zu bestimmen.

13. Hausgerät nach einem der vorhergehenden Ansprüche, **dadurch gekennzeichnet, dass** die Rückseite der Abdeckplatte (10) mit einer einseitig lichtdurchlässigen Spiegelschicht (36) ausgestattet ist.
